# EUROPÄISCHE PATENTSCHRIFT

(11) **EP 0 532 780 B1**
(45) Veröffentlichungstag und Bekanntmachung des Hinweises auf die Patenterteilung: **27.11.1996**
(21) Anmeldenummer: 91115875.6
(22) Anmeldetag: 18.09.1991
(51) Int. Cl.: H03H 19/00

(54) **Integrierbare Schaltungsanordnung mit einem analogen Netzwerk**
Integrated circuit comprising an analog circuit
Montage intégré comportant un circuit analogique

(43) Veröffentlichungstag der Anmeldung: 24.03.1993
(73) Patentinhaber: SIEMENS AKTIENGESELLSCHAFT, 80333 München (DE)
(72) Erfinder: Gazsi, Lajos, Dr., W-4000 Düsseldorf (DE)

(56) Entgegenhaltungen:
- FR-A- 2 532 115
- US-A- 4 803 647
- US-A- 4 809 203
- PROC OF THE 37th ANNUAL FREQUENCY CONTROL SYMPOSIUM 1983; 1-3 JUNE 1983, PHILADELPHIA (US) p.371-375 : R. SCHAUMANN" MICROELECTRONIC ANALOG ACTIVE FILTERS"

## Beschreibung

Die Erfindung betrifft eine integrierbare Schaltungsanordnung mit einem analogen Netzwerk.

Netzwerke von hoher Genauigkeit mit Widerständen und Kapazitäten werden heutzutage überwiegend noch diskret oder in Hybridtechnik ausgeführt. Der schaltungstechnische Aufwand ist dabei sehr hoch, jedoch erfüllen diese Techniken bisweilen am besten die Anforderungen bezüglich absoluter Genauigkeit, Fertigungstoleranz, Langzeitstabilität und Temperaturverhalten (Siehe auch zum Beispiel US-A-4 809 203).

Netzwerke in integrierter Schaltungstechnik dagegen erfordern im allgemeinen einen sehr geringen schaltungstechnischen Aufwand. Sie haben aber den Nachteil, daß die damit erzeugten Widerstände und Kapazitäten starken fertigungsbedingten und temperaturabhängigen Schwankungen unterworfen sind. Eine hohe absolute Genauigkeit und eine hohe Konstanz ist nur mit erheblichem zusätzlichen Aufwand zuerzielen.

Bei M. Banu, Y. Tsividis, An Elliptic Continuous-Time CMOS-Filter With On-Chip Automatic Tuning, IEEE Journal of Solid-State Circuits, Vol. SC-20, No. 6, December 1985 und bei Y. Tsividis, M. Banu, J. Khoury, Continuous-Time MOSFET-C Filters in VLSI, IEEE Journal of Solid-State Circuits, Vol. SC-21, No. 1, February 1986 ist jedoch eine integrierbare Schaltungsanordnung mit einem Filter beschrieben, das zwar die üblichen Kapazitäten aufweist, bei dem aber die Widerstände durch MOS-Feldeffekttransistoren ersetzt werden. Die Ansteuerung der MOS-Feldeffekttransistoren erfolgt durch einen Phasendetektor, dem ein Schleifenfilter nachgeschaltet ist. Der Phasendetektor wiederum vergleicht ein Referenzsignal mit dem Ausgangssignal eines Oszillators oder mit dem Antwortsignal eines weiteren Filters, das durch das Referenzsignal angeregt wird.

Oszillator und weiteres Filter weisen MOS-Feldeffekttransistoren und Kapazitäten auf, die in gleicher Weise aufgebaut sind, wie die MOS-Feldeffekttransistoren und die Kapazitäten des einen Filters. Dabei wird davon ausgegangen, daß bei integrierter Schaltungstechnik anstelle einer hohen absoluten Genauigkeit eine hohe relative Genauigkeit zwischen zwei oder mehreren gleichartig aufgebauten Bauelementen erreicht wird. Der Oszillator oder das weitere Filter sind Bestandteil eines Phasenregelkreises, der bezüglich des Referenzsignals den Oszillator oder das weitere Filter über die MOS-Feldeffekttransistoren mit hoher absoluter Genauigkeit einstellt. Die MOS-Feldeffekttransistoren des einen Filters werden dabei mit den gleichen Signalen wie der Oszillator oder das weitere Filter angesteuert, so daß auch hier eine hohe absolute Genauigkeit erreicht wird.

Ein großer Anwendungsbereich für derartige analoge Netzwerke liegt insbesondere bei Schaltungen in Switched-Capacitor-Technik, die im allgemeinen voll integrierbar sind, bei denen vor bzw. nachgeschaltete Analogfilter jedoch meist diskret aufgebaut werden müssen. Es wird daher angestrebt, auch die Analogfilter mit zu integrieren, wobei der Aufwand dafür möglichst gering sein sollte. Bei der bekannten Lösung ist der Aufwand beim Abgleichen des analogen Regelkreises jedoch sehr hoch.

Aufgabe der Erfindung ist es daher, eine integrierbare Schaltungsanordnung mit einem analogen Netzwerk anzugeben, die diesen Nachteil nicht aufweist.

Die Aufgabe wird gelöst durch eine Schaltungsanordnung gemäß Patentanspruch 1 oder 2. Ausgestaltungen und Weiterbildungen des Erfindungsgedankens sind in Unteransprüchen gekennzeichnet.

Die Erfindung wird nachfolgend anhand der in den Figuren der Zeichnung dargestellten Ausführungsbeispiele näher erläutert.

Es zeigt:
- Figur 1: eine erste Ausführungsform einer erfindungsgemäßen Schaltungsanordnung und
- Figur 2: eine zweite Ausführungsform einer erfindungsgemäßen Schaltungsanordnung.

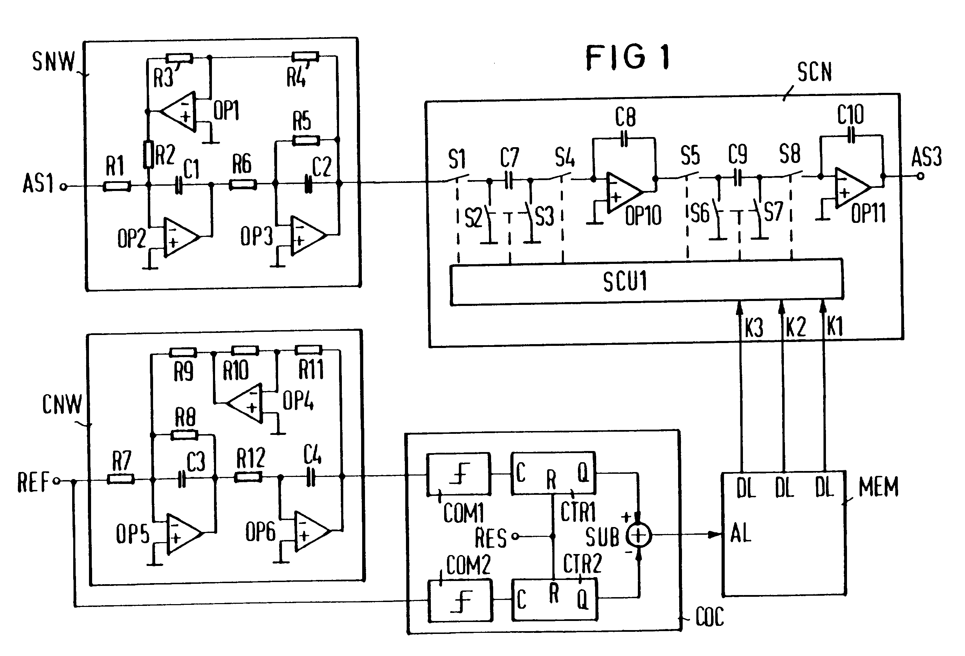

Eine erfindungsgemäße Schaltungsanordnung umfaßt gemäß Figur 1 der Zeichnung ein Widerstände R1...R6 und Kapazitäten C1, C2 aufweisendes analoges Signalnetzwerk SNW, einen diesem nachgeschaltetes Switched-Capacitor-Netzwerk SCN mit einstellbaren Koeffizienten K1, K2, K3. Außerdem ist ein Widerstände R7...R12 und Kapazitäten C3, C4 aufweisendes analoges Vergleichsnetzwerk CNW vorgesehen, dessen Widerstände R7...R12 und Kapazitäten C3, C4 identisch zu den Widerständen R1...R6 und den Kapazitäten T1, T2 des analogen Signalnetzwerkes SNW aufgebaut sind und an das ein Anregungssignal angelegt ist. Schließlich enthält die erfindungsgemäße Schaltungsanordnung eine Auswerteschaltung COC, die ein vom analogen Vergleichsnetzwerk CNW aufgrund des Anregungssignals abgegebenes Antwortsignal mit einem Referenzsignal REF vergleicht und davon abhängig die Koeffizienten K1, K2, K3 des Switched-Capacitor-Netzwerk SCN einstellt.

Das Einstellen der Koeffizienten K1, K2, K3 erfolgt in Weiterbildung der Erfindung mittels eines zwischen Auswerteschaltung COC und Switched-Capacitor Netzwerk SCN geschalteten Speichers MEM, in dem unterschiedliche Werte für die Koeffizienten K1, K2, K3 abgelegt sind. Bei der Einstellung der Koeffizienten K1, K2, K3 des Switched-Capacitor-Netzwerkes SNW werden jeweils bestimmte Werte durch die Auswerteschaltung COC ausgewählt und dem Switched-Capacitor-Netzwerk SNW übergeben. Über Adreßleitungen AL des Speichers MEM wird dazu von der Auswerteschaltung COC dem Speicher MEM ein Datenwort übermittelt, das eine bestimmte Adresse darstellt. Unter dieser Adresse ist im Speicher für jeden Koeffizienten K1, K2, K3 jeweils ein bestimmter Wert abgelegt, der daraufhin an das Switched-Capacitor-Netzwerk SNW über Datenleitungen DL ausgegeben wird.

Die Auswerteschaltung COC besteht aus einem digitalen Phasendetektor mit zwei Zählern CTR1, CTR2 sowie einem Subtrahierer SUB. Der Zähler CTR1 wird dabei mit dem Antwortsignal des Vergleichsnetzwerkes CNW und der Zähler CTR2 mit dem Referenzsignal REF angesteuert. Diese Signale sind jeweils an einen Zähleingang C der betreffenden Zähler CTR1, CTR2 gelegt. Die Ausgänge Q der beiden Zähler CTR1, CTR2 sind auf jeweils einen Eingang des Subtrahierers SUB geführt, dessen Ausgang mit den Adreßleitungen AL des Speichers MEM verschaltet ist. Die Reseteingänge R beider Zähler CTR1, CTR2 sind zusammengeführt und werden in bestimmten Zeitabständen durch ein Rücksetzsignal RES zurückgesetzt. Den beiden Zählern CTR1, CTR2 sind jeweils Komparatoren COM1, COM2 vorgeschaltet, um die Flankensteilheit der betreffenden Signale, insbesondere jedoch des Antwortsignals des Vergleichsnetzwerkes CNW, zu erhöhen.

Das Vergleichsnetzwerk CNW ist durch ein Bandpaßfilter mit drei Operationsverstärkern OP4, OP5, OP6 gegeben, deren nichtinvertierende Eingänge jeweils auf einem Bezugspotential liegen und die zwischen Ausgang und invertierendem Eingang gegengekoppelt sind. Dabei ist der Operationsverstärker OP4 über einen Widerstand R10, der Operationsverstärker OP6 über eine Kapazität C4 und der Operationsverstärker OP5 über eine Kapazität C3 und einen dazu parallel geschalteten Widerstand R8 gegengekoppelt. Der invertierende Eingang des Operationsverstärkers OP6 ist über einen Widerstand R12 mit dem Ausgang des Operationsverstärkers OP5 verbunden, dessen invertierender Eingang wiederum zum einen über einen Widerstand R9 mit dem Ausgang des Operationsverstärkers OP4 gekoppelt ist und zum anderen über einen Widerstand R7 mit dem Anregungssignal, nämlich dem Referenzsignal REF, beaufschlagt ist. Der invertierende Eingang des Operationsverstärkers OP4 ist über einen Widerstand R11 mit dem Ausgang des Operationsverstärkers OP6 gekoppelt, der gleichzeitig auch den Ausgang des Vergleichsnetzwerkes CNW bildet und somit das Antwortsignal führt.

Das analoge Signalnetzwerk SNW besteht ebenfalls aus drei Operationsverstärkern OP1, OP2 und OP3, deren nichtinvertierende Eingänge auf dem Bezugspotential liegen. Der Operationsverstärker OP1 ist über einen Widerstand R3, der Operationsverstärker OP2 über eine Kapazität C1 und der Operationsverstärker OP3 über eine Kapazität C2 und einen dazu parallel geschalteten Widerstand R5 zwischen Ausgang und invertierendem Eingang gegengekoppelt. Der invertierende Eingang des Operationsverstärkers OP1 ist über einen Widerstand R4 mit dem Ausgang des Operationsverstärkers OP3 verbunden, dessen invertierender Eingang wiederum über einen Widerstand R6 mit dem Ausgang des Operationsverstärkers OP2 gekoppelt ist. Der invertierende Eingang des Operationsverstärkers OP2 ist über einen Widerstand R2 an den Ausgang des Operationsverstärkers OP1 und über einen Widerstand R1 an ein analoges Signal AS1 angeschlossen. An den Ausgang des Operationsverstärkers OP3 ist das Switched-Capacitor-Netzwerk SCN angeschlossen.

Das Switched-Capacitor-Netzwerk SCN nach Figur 1 enthält zwei Operationsverstärker OP10 und OP11, deren nichtinvertierende Eingänge auf dem Bezugspotential liegen und deren Ausgänge und invertierende Eingänge über jeweils eine Kapazität C8 bzw. C10 miteinander gekoppelt sind. Am Ausgang des Operationsverstärkers OP11 liegt ein Analogsignal AS3 an. Der invertierende Eingang des Operationsverstärkers OP10 ist des weiteren über einen gesteuerten Schalter S1, eine Kapazität C7 und einem gesteuerten Schalter S4 in Reihe an den Ausgang des analogen Signalnetzwerkes SNW angeschlossen. Zudem sind die beiden Anschlüsse der Kapazität C7 über jeweils einen gesteuerten Schalter S2 bzw. S3 auf das Bezugspotential aufschaltbar. In gleicher Weise ist der invertierende Eingang des Operationsverstärkers OP11 über einen gesteuerten Schalter S5, eine Kapazität C9 und einen Schalter S8 in Reihe an den Ausgang des Operationsverstärkers OP10 angeschlossen. Die beiden Anschlüsse der Kapazität C9 sind über jeweils einen gesteuerten Schalter S6 bzw. S7 auf das Bezugspotential aufschaltbar. Die Steuerung der Schalter S1 bis S8 erfolgt mittels einer Steuereinheit SCU1, die entsprechende Steuersignale aus den vor dem Speicher MEM übergebenen Koeffizienten K1, K2, K3 ableitet.

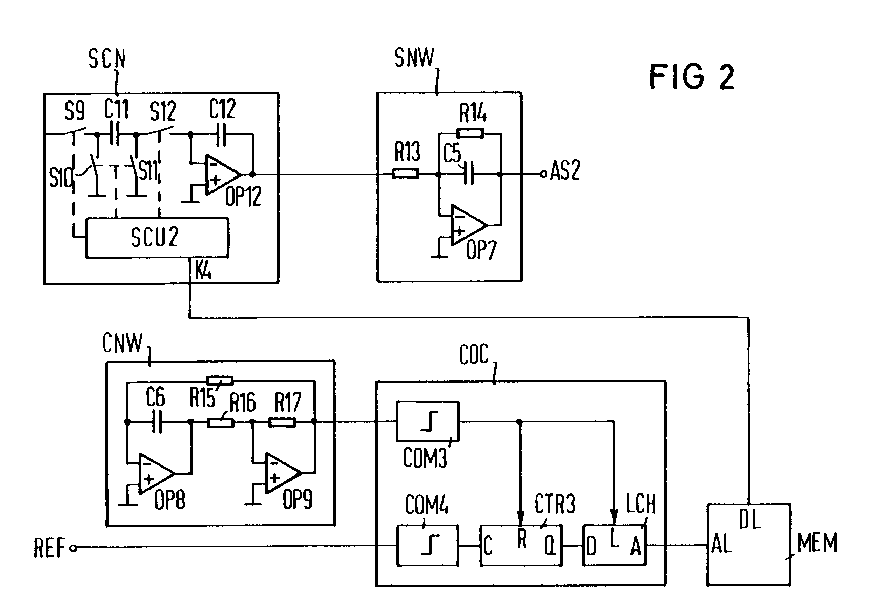

Das Ausführungsbeispiel nach Figur 2 ist gegenüber dem nach Figur 1 dahingehend abgeändert, daß das Switched-Capacitor-Netzwerk SCN eingangsseitig mit einem Analogsignal AS4 beaufschlagt ist, und daß diesem das analoge Signalnetzwerk SNW folgt.

Das Switched-Capacitor-Netzwerk SCN enthält einen Operationsverstärker OP12, bei dem der nichtinvertierende Eingang auf Bezugspotential liegt und bei dem Ausgang und invertierender Eingang über eine Kapazität C12, miteinander gekoppelt sind. Der nichtinvertierende Eingang des Operationsverstärkers OP12 ist über einen gesteuerten Schalter S9, eine Kapazität C11 und einen Schalter S12 mit dem Analogsignal AS4 beaufschlagbar. Die beiden Anschlüsse der Kapazität C11 sind über jeweils einen Schalter S10 bzw. S11 auf das Bezugspotential aufschaltbar. Die Steuerung der Schalter S9 bis S12 erfolgt durch eine Steuereinheit SCU2, die abhängig von einem Koeffizienten K4 entsprechende Steuersignale erzeugt.

Das analoge Signalnetzwerk SNW enthält einen Operationsverstärker OP7, dessen nichtinvertierender Eingang auf dem Bezugspotential liegt und der zwischen Ausgang und invertierendem Eingang über einen Widerstand R14 und eine parallel dazu geschaltete Kapazität C5 rückgekoppelt ist. Der invertierende Eingang des Operationsverstärkers OP7 ist darüber hinaus über einen Widerstand R13 mit dem Ausgang des Switched-Capacitor-Netzwerkes SCN verbunden. Am Ausgang des Operationsverstärkers OP7, der den Ausgang des analogen Signalnetzwerkes SNW bildet, liegt ein analoges Signal AS2 an.

Der Koeffizient K4 für das Switched-Capacitor-Netzwerk SCN wird durch den Speicher MEM über seine Datenleitungen DL bereitgestellt. Die Auswahl des entsprechenden Speicherplatzes erfolgt wiederum über die Adreßleitungen AL, die an den Ausgang der Auswerteschaltung COC angeschlossen sind. Die Auswerteschaltung COC beinhaltet beim Ausführungsbeispiel nach Figur 2 einen digitalen Frequenzvergleicher, der im wesentlichen einen Zähler CTR3 und ein Latch LTH aufweist. An den Rücksetzeingang R des Zählers CTR sowie an einen Steuereingang L des Speicherelementes LCH ist das Antwortsignal des Vergleichsnetzwerkes CNW gelegt. Der Zähleingang des Zählers CTR ist mit dem Referenzsignal REF beaufschlagt. Des weiteren sind zwei Komparatoren COM3, COM4 vorgesehen, welche zur Erhöhung der Flankensteilheit des Antwortsignals und des Referenzsignals REF dem Rücksetzeingang des Zählers CTR3 und des Steuereingangs L des Speicherelementes LCH bzw. dem Zähleingang C des Zählers CTR3 vorgeschaltet sind.

Das Vergleichsnetzwerk CNW ist beim Ausführungsbeispiel nach Figur 2 durch eine Oszillatorschaltung gegeben. Die Oszillatorschaltung besteht aus zwei Operationsverstärkern OP8 und OP9, deren nichtinvertierende Eingänge auf Bezugspotential liegen. Der nichtinvertierende Eingang und der Ausgang sind beim Operationsverstärker OP8 über eine Kapazität C6 und beim Operationsverstärker OP9 über einen Widerstand R17 miteinander gekoppelt. Der Ausgang des Operationsverstärkers OP9 ist zudem über einen Widerstand R15 mit dem nichtinvertierenden Eingang des Operationsverstärkers OP8 verbunden, dessen Ausgang wiederum über einen Widerstand R16 mit dem invertierenden Eingang des Operationsverstärkers OP9 gekoppelt ist. Am Ausgang des Operationsverstärkers OP9 liegt das Antwortsignal des analogen Vergleichsnetzwerkes CNW an, das gleichzeitig auch das Anregungssignal darstellt.

Bei einer erfindungsgemäßen Schaltungsanordnung wird immer von einem gemischten System mit kontinuierlichen analogen Netzwerken und Switched-Capacitor-Netzwerken ausgegangen. Es werden dabei immer mindestens zwei Netzwerke vorgesehen, von denen das eine kontinuierlich, analog in Switched-Capacitor-Technik und das andere realisiert ist. Das Switched-Capacitor-Netzwerk SCN wird dabei immer so eingestellt, daß es die Schwankungen des analogen Signalnetzwerkes SNW ausgleicht und das Gesamtübertragungsverhalten konstant gehalten wird. Dazu werden die Schwankungen des Übertragungsverhaltens des analogen Signalnetzwerkes SNW bestimmt. Dies geschieht mittels des analogen Vergleichsnetzwerkes CNW, dessen Übertragungsverhalten sich proportional zu dem des Signalnetzwerkes SNW verändert. Die Änderungen im Übertragungsverhalten des analogen Vergleichsnetzwerkes CNW werden mittels der Auswerteschaltung COC ermittelt und daraufhin der bzw. die Koeffizienten des digitalen Signalnetzwerkes DNW entsprechend geändert. Es handelt sich dabei also um einen Steuerkreis, im Gegensatz zu der bekannten Anordnung, bei der es sich um einen Regelkreis, genauer gesagt um einen Phasenregelkreis, handelt. Darüber hinaus wird bei der erfindungsgemäßen Schaltungsanordnung wiederum im Gegensatz zur bekannten Anordnung die analogen Netzwerke, das Signalnetzwerk SNW und das Vergleichsnetzwerk CNW, nicht verändert. Die verwendeten Widerstände R1...R17 sind also nicht steuerbar. Diese Widerstände R1...R17 sind abgesehen von temperatur- und produktionsbedingten Schwankungen insofern als konstant anzusehen.

Der Aufbau des analogen Signalnetzwerkes SNW ist prinzipiell beliebig und hängt im wesentlichen vom jeweiligen Anwendungsfall ab. Das bedeutet, daß neben den gezeigten Ausführungsformen mit Tiefpassverhalten eine Vielzahl weiterer Ausführungsformen möglich sind, die sich beispielsweise im Übertragungsverhalten und/oder der schaltungstechnischen Realisierung unterscheiden. So ist neben der gezeigten unsymmetrischen ebenso eine symmetrische Ausbildung des Signalnetzwerkes SNW möglich.

Ebenso ist das Switched-Capacitor-Netzwerk SCN auf vielfältige Weise realisierbar. Das Übertragungsverhalten des Switched-Capacitor-Netzwerkes SCN ist auf das Übertragungsverhalten des analogen Signalnetzwerkes SNW abgestimmt. Durch Ändern des bzw. der Koeffizienten K1...K4 wird das Übertragungsverhalten derart beeinflußt, daß die Schwankungen beim Übertragungsverhalten des analogen Signalnetzwerkes SNW ausgeglichen werden. Bei der Realisierung können in gleicher Weise symmetrisch oder unsymmetrische Strukturen verwendet werden.

Die Einstellung der Koeffizienten K1...K4 soll in Abhängigkeit von den Schwankungen des analogen Signalnetzwerkes SNW erfolgen. Die Schwankungen des analogen Signalnetzwerkes SNW werden dabei aber nicht direkt gemessen, sondern es werden stattdessen die Schwankungen des Vergleichsnetzwerkes CNW ermittelt. Dabei wird davon ausgegangen, daß die Schwankungen des Vergleichsnetzwerkes CNW proportional zu den Schwankungen des analogen Signalnetzwerkes SNW sind. Das heißt also, daß das Vergleichnetzwerk CNW in gleicher Weise den Schwankungen unterworfen ist wie das analoge Signalnetzwerk SNW. Um einen Gleichlauf der Schwankungen zu erzielen, werden beispielsweise das Übertragungsverhalten bestimmende Widerstände R1...R17 und Kapazitäten C1...C6 bei Signalnetzwerk SNW und Vergleichsnetzwerk CNW identisch ausgeführt. Unterschiedliche Widerstands- und Kapazitätswerte werden dabei durch Parallel- bzw. Reihenschaltung gleicher Elemente erzeugt. Die relative Genauigkeit und der Gleichlauf der einzelnen Elemente untereinander ist bei der Realisierung in integrierter Technik im allgemeinen von Hause aus sehr hoch. Signalnetzwerk SNW und Vergleichsnetzwerk CNW müssen allerdings nicht ein identisches Übertragungsverhalten aufweisen. So kann es sich beispielsweise beim Signalnetzwerk SNW auch um ein Tiefpaßfilter handeln, während es sich beim Vergleichsnetzwerk CNW um ein Bandpaßfilter oder um ein Rückkopplungsnetzwerk eines Oszillators mit Bandpaßverhalten handelt.

Zur Ermittlung der Schwankungen des Vergleichsnetzwerkes CNW mißt die Auswerteschaltung COC eine für die Schwankung des Übertragungsverhaltens charakteristische Größe. Diese charakteristische Größe ist bei dem Ausführungsbeispiel nach Figur 1 die Phase und bei dem Ausführungsbeispiel nach Figur 2 die Frequenz des Antwortsignals des Vergleichsnetzwerkes CNW. Bei der Phasenmessung wird davon ausgegangen, daß im Durchlaßbereich eines Bandpasses die Phasenverschiebung gleich Null ist. Wird nun der Bandpaß als analoges Vergleichsnetzwerk CNW mit dem Referenzsignal REF angesteuert und anschließend das Antwortsignal mit diesem verglichen, so können Änderungen des Durchlaßbereiches aufgrund von Änderungen der Widerstands- und Kapazitätswerte als Phasenverschiebung festgestellt werden. Dagegen wird bei dem Ausführungsbeispiel nach Figur 2 die Frequenz eines Oszillators gemessen, der als frequenzbestimmende Elemente einen Widerstand und Kapazität aufweist. Durch die Auswerteschaltung COC wird hierbei die Frequenz des Oszillators im Bezug auf die Frequenz des Referenzsignals REF ermittelt und es werden somit Änderungen der Widerstands- und Kapazitätswerte als Frequenzänderungen festgestellt.

In Weiterbildung der Erfindung ist die Auswerteschaltung COC als digitale Phasenvergleicher bzw. Frequenzvergleicher ausgeführt, die unter anderem einen oder mehrere Zähler aufweisen. Die Phasen- bzw. Frequenzunterschiede werden dabei jeweils als digitale Größe ausgegeben. Das hat den Vorteil, daß kein zusätzlicher Analog-Digital-Wandler benötigt wird und der schaltungstechnische Aufwand damit insgesamt sehr gering ist.

Durch Verwendung des Speichers MEM, der den von der Auswerteschaltung COC ermittelten Wert der Schwankung in eine entsprechende Änderung des bzw. der Koeffizienten K1...K4 umsetzt, ist eine Abstimmung des digitalen Signalnetzwerkes DNW auf das analoge Signalnetzwerk SNW zum einen leicht maschinell, insbesondere rechnergesteuert, durchführbar und zum anderen ist damit eine hohe absolute Genauigkeit erzielbar.

Darüber hinaus zeichnet sich eine erfindungsgemäße Schaltungsanordnung durch einen sehr geringen analogen Schaltungsaufwand, und aufgrund der überwiegend digital realisierten Funktionen durch eine große Reproduzierbarkeit aus. Außerdem sind Rückwirkungen auf den Signalzweig äußerst gering, da wergen der Verwendung eines Steuerkreises anstelle eines Regelkreises Einschwingverhalten und Regelverhalten entfallen und somit keinen Einfluß auf den Signalzweig haben.

Abschließend sei daraufhingewiesen, daß die Auswerteschaltung COC bevorzugt Hystereseverhalten aufweist. Dazu sind beispielsweise die Zähler CTR1, CTR2, CTR3 oder der Subtrahierer SUB entsprechend ausgebildet. Bei einer Änderung des Übertragungsverhaltens des analogen Vergleichsfilters CNW erfolgt erst ab einem bestimmten Schwellenwert auch eine Änderung der Adressen auf den Adressleitungen AL. Der Schwellenwert ist dabei, wie bei Hystereseverhalten üblich, je nach Richtung der Änderung unterschiedlich. Außerdem sind darüber hinaus die analogen Signalnetzwerke außer mit den digitalen Netzwerken zusätzlich auch mit Switched-Capacitor-Netzwerken, die ebenfalls durch die Auswerteschaltung gesteuert werden, kombinierbar.

## Patentansprüche

1. Integrierbare Schaltungsanordnung
mit einem Schwankungen unterworfenen analogen Signalnetzwerk (SNW),
mit einem zum analogen Signalnetzwerk (SNW) in Reihe geschalteten Switched-Capacitor-Netzwerk (SCN),
mit einstellbaren Koeffizienten (K1, K2, K3),
mit einem den Schwankungen in gleicher Weise unterworfenen analogen Vergleichsnetzwerk (CNW), an das ein Anregungssignal angelegt ist, und mit einer Auswerteschaltung (COC), die ein vom analogen Vergleichsnetzwerk (CNW) aufgrund des Anregungssignals abgegebenes Antwortsignal mit einem Referenzsignal (REF) vergleicht und davon abhängig die Koeffizienten (K1, K2, K3) des Switched-Capacitor-Netzwerkes (SCN) einstellt.

2. Schaltungsanordnung nach Anspruch,
**gekennzeichnet durch** einen zwischen Auswerteschaltung (COC) und Switched-Capacitor-Netzwerk (SCN) schalteten Speicher (MEM), in dem unterschiedliche Werte für die Koeffizienten (K1...K4) abgelegt sind, wobei zur Einstellung der Koeffizienten (K1...K4) des Switched-Capacitor-Netzwerkes (SCN) jeweils bestimmte Werte durch die Auswerteschaltung (COC) ausgewählt werden.

3. Schaltungsanordnung nach einem der Ansprüche 1 oder 2,
**gekennzeichnet durch** einen Bandpaß (OP3, OP4, OP5, R7...R12, C3, C4) als analoges Vergleichsnetzwerk (CNW), an den als Anregungssignal das Referenzsignal (REF) angelegt ist.

4. Schaltungsanordnung nach einem der Ansprüche 1 oder 2,
**dadurch gekennzeichnet,** daß das analoge Vergleichsnetzwerk (CNW) durch eine Oszillatorschaltung (OP8, OP9, C6, R15, R16, R17) gegeben ist, bei der das Anregungssignal gleich dem Antwortsignal ist.

5. Schaltungsanordnung nach Anspruch 3,
**dadurch gekennzeichnet,** daß die Auswerteschaltung (COC) einen digitalen Phasendetektor (CTR1, CTR2, SUB) aufweist.

6. Schaltungsanordnung nach Anspruch 4,
**dadurch gekennzeichnet,** daß die Auswerteschaltung (COC) einen digitalen Frequenzdetektor (CTR3, LCH) aufweist.

7. Schaltungsanordnung nach einem der Ansprüche 1 bis 6,
**dadurch gekennzeichnet,** daß analoges Signalnetzwerk (SNW) und analoges Vergleichsnetzwerk (CNW) identisch aufgebaute Widerstände (R1...R17) und Kapazitäten (C1...C6) enthalten.

## Claims

1. Integrable circuit arrangement having an analog signal network (SNW) which is subject to fluctuations,
having a switched-capacitor network (SCN) which is connected in series with the analog signal network (SNW), having adjustable coefficients (K1, K2, K3),
having an analog comparison network (CNW) which is subject in the same way to the fluctuations and to which an excitation signal is applied, and having an evaluation circuit (COC) which compares a response signal emitted by the analog comparison network (CNW) on account of the excitations signal with a reference signal (REF) and sets the coefficients (K1, K2, K3) of the switched-capacitor network (SCN) as a function thereof.

2. Circuit arrangement according to Claim 1, characterized by a memory (MEM) which is connected between the evaluation circuit (COC) and the switched-capacitor network (SCN) and in which various values for the coefficients (K1...K4) are stored, the evaluation circuit (COC) selecting specific values for setting each of the coefficients (K1...K4) of the switched-capacitor network (SCN).

3. Circuit arrangement according to either of Claims 1 and 2, characterized by a bandpass filter (OP3, OP4, OP5, R7...R12, C3, C4) as the analog comparison network (CNW), to which filter the reference signal (REF) is applied as the excitation signal.

4. Circuit arrangement according to either of Claims 1 and 2, characterized in that the analog comparison network (CNW) is formed by an oscillator circuit (OP8, OP9, C6, R15, R16, R17) in which the excitation signal is equal to the response signal.

5. Circuit arrangement according to Claim 3, characterized in that the evaluation circuit (COC) has a digital phase detector (CTR1, CTR2, SUB).

6. Circuit arrangement according to Claim 4, characterized in that the evaluation circuit (COC) has a digital frequency detector (CTR3, LCH).

7. Circuit arrangement according to one of Claims 1 to 6, characterized in that the analog signal network (SNW) and the analog comparison network (CNW) contain identically constructed resistors (R1...R17) and capacitors (C1...C6).

## Revendications

1. Montage pouvant être intégré
comportant un réseau (SNW) pour signaux analogiques soumis à des fluctuations,
un réseau SCN à capacités commutées branché en série avec le réseau (SNW) pour signaux analogiques,
des coefficients réglables (K1, K2, K3),
un réseau (CNW) de comparaison analogique soumis de la même manière aux fluctuations, auquel est appliqué un signal d'excitation, et un circuit (COC) d'exploitation, qui compare un signal de réponse fourni par le réseau (CNW) de comparaison analogique sur la base du signal d'excitation, à un signal (REF) de référence et qui règle, en fonction de cette comparaison, les coefficients (K1, K2, K3) du réseau (SCN) à capacités commutées.

2. Montage suivant la revendication 1,
caractérisé par une mémoire (MEM) qui est branchée entre le circuit (COC) d'exploitation et le réseau (SCN) à capacités commutées, dans lequel sont mémorisées des valeurs différentes pour les coefficients (K1 à K4), des valeurs déterminées étant sélectionnées par le circuit (COC) d'exploitation pour régler les coefficients (K1 à K4) du réseau (SCN) à capacités commutées.

3. Montage suivant l'une des revendications 1 et 2,
caractérisé par un passe-bande (OP3, OP4, OP5, R7 à R12, C3, C4) en tant que réseau (CNW) analogique de comparaison, auquel est appliqué en tant que signal d'excitation le signal (REF) de référence.

4. Montage suivant l'une des revendications 1 et 2,
caractérisé en ce que le réseau (CNW) analogique de comparaison est défini par un circuit oscillateur (OP8, OP9, C6, R15, R16, R17), dans lequel le signal d'excitation est égal au signal de réponse.

5. Montage suivant la revendication 3,
caractérisé en ce que le circuit (COC) d'exploitation comporte un détecteur numérique de phase (CTR1, CTR2, SUB).

6. Montage suivant la revendication 4,
caractérisé en ce que le circuit (COC) d'exploitation comporte un détecteur numérique de fréquence (CTR3, LCH).

7. Montage suivant l'une des revendications 1 à 6, caractérisé en ce que le réseau (SNW) pour signaux analogiques et le réseau (CNW) de comparaison analogique comprennent des résistances (R1 à R17) et des capacités (C1 à C7) de structure identique.
